# EUROPÄISCHE PATENTSCHRIFT

(11) **EP 3 021 335 B1**
(45) Veröffentlichungstag und Bekanntmachung des Hinweises auf die Patenterteilung: **26.12.2018**
(21) Anmeldenummer: 14192611.3
(22) Anmeldetag: 11.11.2014
(51) Int. Cl.: H01F 27/34, H01F 27/38

(54) **Anordnung und Verfahren zur Verringerung eines magnetischen Gleichfluss-Anteils im Kern eines Transformators**
Assembly and method for reducing a magnetic unidirectional flux component in the core of a transformer
Système et procédé de réduction d'une part de flux continu magnétique dans le noyau d'un transformateur

(43) Veröffentlichungstag der Anmeldung: 18.05.2016
(73) Patentinhaber: Siemens Aktiengesellschaft, 80333 München (DE)
(72) Erfinder: Hamberger, Peter, 4202 Kirchschlag bei Linz (AT)
(74) Vertreter: Maier, Daniel Oliver

(56) Entgegenhaltungen:
- WO-A1-2008/151661
- WO-A1-2012/041367
- WO-A1-2012/041368
- DE-A1- 3 237 584

## Beschreibung

### Technisches Gebiet

Die Erfindung betrifft allgemein elektrische Transformatoren wie Sie in Energie-Übertragungs- und Verteilungsnetzen eingesetzt werden, insbesondere eine Anordnung nach dem Oberbegriff von Anspruch 1.

### Stand der Technik

Bei elektrischen Transformatoren, wie sie in Energie-Übertragungs- und Verteilungsnetzen eingesetzt werden, kann es zu einer unerwünschten Einspeisung eines Gleichstroms in die Primärwicklung bzw. Sekundärwicklung kommen. Eine solche Gleichstromeinspeisung, im Folgenden auch als DC-Anteil bezeichnet, kann beispielsweise von leistungselektronischen Baukomponenten herrühren, wie sie heutzutage bei der Ansteuerung von elektrischen Antrieben, oder auch bei der Blindleistungskompensation verwendet werden. Eine andere Ursache können so genannte "Geomagnetically Induced Currents" (im Folgenden auch kurz als GIC bezeichnet) sein. DC-Einspeisung und GIC können bei einem Transformator auch gleichzeitig vorhanden sein.

Ein DC-Anteil bzw. ein GIC hat im Kern des Transformators einen magnetischen Gleichfluss-Anteil zur Folge, der sich dem Wechselfluss überlagert. Es kommt zu einer unsymmetrischen Aussteuerung des magnetischen Werkstoffs im Kern was eine Reihe von Nachteilen mit sich bringt. Bereits ein Gleichstrom von wenigen Ampere führt zu einer signifikanten Erhöhung der Verluste (z.B.: 20-30%). Erwärmungsprobleme treten insbesondere bei großem GIC auf. Eine lokale Erwärmung im Transformator kann die Lebensdauer der Wicklungsisolation beeinträchtigen. Es kommt ferner bei Betrieb zu einer erhöhten Geräuschemission, die insbesondere dann als besonders störend empfunden wird, wenn der Transformator in der Nähe eines Wohnbereichs installiert ist.

Zur DC-Kompensation bzw. Verringerung von Betriebsgeräuschen eines Transformators sind verschiedene aktiv und passiv wirkende Einrichtungen bekannt. In der WO 2012/041368A1 wird beispielsweise vorgeschlagen, die in der Kompensationswicklung induzierte elektrische Spannung zu nutzen und für die Kompensation des störenden magnetischen Gleichfluss-Anteils heranzuziehen. Dies wird mittels einer elektronischen Schalteinheit bewirkt, die durch Taktung von Halbleiterschaltelementen einen pulsierenden Kompensationsstrom erzeugt der in die Kompensationswicklung eingespeist wird. Der Einschaltzeitpunkt wird dabei von der Phase der in der Kompensationswicklung induzierten Spannung getriggert. Die Einschaltdauer richtet sich nach Maßgabe eines Sensorsignals, welche den zu kompensierenden Gleichfluss-Anteil erfasst und als Messsignal bereitstellt. Dabei ist keine gesonderte Energiequelle erforderlich. Als Schaltelemente kann beispielsweise ein Thyristor verwendet werden, der gezündet wird und dann automatisch bei Stromnulldurchgang wieder sperrt. Die Größe des Kompensationsstroms kann über den Phasenwinkel eingestellt werden.

Die Lebensdauer eines Halbleiterschaltelements ist aber stark von der Temperatur abhängig. Zum Schutz vor Überlastung sind Kühleinrichtungen erforderlich. Die maximal mögliche Erwärmung begrenzt den maximalen Strom, der über den Thyristor geführt werden darf. Ein weiteres Problem ist die in der Kompensationswicklung induzierte elektrische Spannung, die in der Praxis derzeit einen Einsatz einer DC-Kompensation auf 690 V beschränkt. Bei sehr großen Transformatoren, wie sie zum Beispiel für HGÜ (Hochspannung-GleichstromÜbertragung) eingesetzt werden, kann die Windungsspannung an der Kompensationswicklung aber weit über 690 V liegen. Heutzutage ist zwar der Einsatz von Thyristoren für 5kV, 8kV und auch darüber denkbar, der Kostenaufwand aber hoch. Bisher entwickelte Lösungsansätze der Gleichflusskompensation decken daher nur den Bereich der Niederspannungsrichtlinie ab. Mit den gegenwärtigen Möglichkeiten der Halbleitertechnik ist daher die Anwendung der Gleichflusskompensation nur eingeschränkt möglich. Außerdem ist die Zuverlässigkeit bei DC-Kompensations-Anlagen unbefriedigend. Die von einer Halbleiterschalteinrichtung samt Kühlvorrichtung zu erwartende Lebensdauer ist im Vergleich zur Lebensdauer eines Leistungstransformators, der über mehrere Jahrzehnte zuverlässig funktionieren soll, viel geringer. Andererseits herrscht aber gerade bei Leistungstransformatoren eine große Nachfrage nach einer praxistauglichen Gleichfluss-Kompensation, die über einen langen Betriebszeitraum zuverlässig funktioniert, die technisch einfach aufgebaut ist und kostengünstig herstellbar ist.

Aus der WO2012/041367 A1 ist eine Anordnung zum Verringern eines Gleichfeldanteils im Kern eines Transformators bekannt, bei der zur Einspeisung eines Kompensationsstroms in die Kompensationswicklung eines Transformators ein Reaktanzzweipol vorgesehen ist, bei dem im Parallelzweig des Kondensators die Spannung herabgesetzt ist. Diese Herabsetzung der Spannung wird dadurch erreicht, dass die Induktivität nach Art eines Koppeltransformators ausgebildet ist.

### Darstellung der Erfindung

Es ist eine Aufgabe der vorliegenden Erfindung eine Anordnung zur Verringerung eines Gleichfluss-Anteils eines magnetischen Flusses in einem Kern eines Transformators anzugeben, wobei im praktischen Einsatz für Transformatoren in einem Energie-Übertragungs- und Verteilungsnetz eine möglichst hohe Zuverlässigkeit erreicht werden kann und die Realisierung möglichst einfach ist.

Diese Aufgabe wird gelöst mit einer Anordnung gemäß Anspruch 1. Vorteilhafte Ausgestaltungen der Erfindung ergeben sich aus den abhängigen Ansprüchen.

Gemäß einem Grundgedanken der vorliegenden Erfindung wird zum Erzeugen des Kompensationsstroms die bislang im Stand der Technik verwendete Leistungselektronik durch Baukomponenten ersetzt, denen ausschließlich ein magnetisches Wirkprinzip zu Grunde liegt.
Die Erfindung geht von einer Anordnung zur Verringerung eines magnetischen Gleichfluss-Anteils (Φ_{DC)} im Kern eines Transformators gemäß Anspruch 1.

Im Unterschied zu den bislang in Halbleitertechnik ausgeführten Schaltvorrichtungen besteht die erfindungsgemäße Schaltvorrichtung aus einen magnetischen Kern und einer mit diesem Kern magnetisch gekoppelte Wicklungsanordnung; diese Wicklungsanordnung kann lediglich aus einer Steuerwicklung und einer Arbeitswicklung bestehen. In die Steuerwicklung wird ein Steuerstrom eingespeist, so dass der magnetische Sättigungszustand des Kerns durch diese Steuergröße änderbar ist. Durch die Änderung des Sättigungszustandes im Kern kann die Schalteinheit zwischen einem leitenden und einem nicht leitenden Zustand geschalteten werden. Im Ergebnis wird dadurch eine ähnliche Schaltfunktion erreicht, wie sie bislang durch Halbleiter bewerkstelligt wurde. Im Folgenden wird die magnetisch wirkende Schaltvorrichtung daher auch als "induktiver" oder "magnetischer" Schalter bezeichnet.

Der Wegfall leistungselektronischer Baukomponente ist bei der DC-Kompensation ein großer Vorteil. Dadurch vergrößert sich die Zuverlässigkeit der DC-Kompensations-Anlage und hat eine vergleichsweise höhere Lebensdauer. Der technische Aufbau ist sehr einfach, lässt sich mit sehr geringen Kosten realisieren und arbeitet verschleißfrei.

Die Anwendungsgrenze der Gleichfluss-Kompensation kann nach oben verschoben werden: die an der Kompensationswicklung anstehende Spannung, die heutzutage in der Praxis bei etwa 700 V eine Hürde für die Anwendung der Gleichfluss-Kompensation mit Halbleitern darstellt, ist nicht mehr die Grenze. Die Erfindung ermöglicht die Anwendung der Gleichfluss-Kompensation auch bei höheren Spannungen und damit bei Transformatoren sehr großer Leistung, zum Beispiel bei HGÜ-Transformatoren.

Es können vergleichsweise größere Kompensations-Ströme erzeugt und in die Kompensationswicklung eingespeist werden. Bislang waren diese Speiseströme durch das Leistungsvermögen der Halbleiter, d.h. durch die maximale zulässige Verlustleistung am Thyristor beschränkt. Die erfindungsgemäße Anordnung eröffnet die Anwendung auch für die GIC-Kompensation.

Dabei ist die Wicklungsanordnung aus einer Steuerwicklung, die mit der Steuereinheit verbunden ist, und einer Arbeitswicklung, die in den Strompfad eingebunden ist, gebildet. Dadurch entsteht ein Transduktor, der über die magnetische Aussteuerung des Kernmaterials die Induktivität der Arbeitswicklung steuert. Diese Schaltungsanordnung ist einfach und mit sehr geringen Kosten herstellbar.

Besonders vorteilhaft kann eine Ausführung sein, bei der die Arbeitswicklung so ausgebildet ist, dass sie gleichzeitig als Einrichtung zur Strombegrenzung im Strompfad dient. D.h. dass im leitenden Zustand der Transduktor als Drossel wirkt. Die Selbstinduktivität dieser Drossel ist so bemessen, dass sie eine Strombegrenzung im Strompfad bewirkt. Eine gesonderte Drossel ist dann zur Strombegrenzung nicht mehr erforderlich.

Ein weiterer Vorteil ergibt sich dadurch, dass die aus Wicklungsanordnung und Magnetkern gebildete Schaltvorrichtung leicht innerhalb des Transformatorkessels untergebracht werden kann. Dadurch wird die im Kessel enthaltene Isolations- und Kühlflüssigkeit gleichzeitig für eine sehr effiziente Kühlung der Wicklung der Schaltvorrichtung verwendet. Diese zuverlässige und gleichzeitig einfache Kühlung ermöglicht die Erweiterung des Anwendungsbereiches zu sehr hohen Kompensationsströmen.

Auch beim Nachrüsten oder Umrüsten oder Nachrüsten ist es vorteilhaft sein, wenn die magnetisch wirkende Schalteinrichtung wieder im Transformatorkessel angeordnet wird, so dass die vorhandene Isolations- und Kühlflüssigkeit neben Primär- und Sekundärwicklungen gleichzeitig auch die Wicklungsanordnung der "magnetisch wirkenden" Schalteinrichtung kühlt. Da die erfindungsgemäße Schaltereinrichtung nur ein geringes Bauvolumen beansprucht, ist die Anordnung innerhalb des Kessels unproblematisch.

Ein weiterer Vorteil ergibt sich dadurch, dass die aus Wicklungsanordnung und Magnetkern gebildete Schaltvorrichtung leicht innerhalb des Transformatorkessels untergebracht werden kann. Dadurch wird die im Kessel enthaltene Isolations- und Kühlflüssigkeit gleichzeitig für eine sehr effiziente Kühlung der Wicklung der Schaltvorrichtung verwendet. Diese zuverlässige und gleichzeitig einfache Kühlung ermöglicht die Erweiterung des Anwendungsbereiches zu sehr hohen Kompensationsströmen.

Auch beim Nachrüsten oder Umrüsten ist es vorteilhaft wenn die magnetisch wirkende Schalteinrichtung wieder im Transformatorkessel angeordnet wird, so dass die vorhandene Isolations- und Kühlflüssigkeit neben Primär- und Sekundärwicklungen gleichzeitig auch die Wicklungsanordnung der "magnetisch wirkenden" Schalteinrichtung kühlt. Da die erfindungsgemäße Schaltereinrichtung nur ein geringes Bauvolumen beansprucht, ist die Anordnung innerhalb des Kessels unproblematisch.

### Kurzbeschreibung der Zeichnung

In weiterer Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind. Es zeigen:
- Figur 1: ein Blockschaltbild, anhand dessen allgemein das Wirkprinzip einer Gleichfluss-Kompensation mit einer getakteten Schalteinheit zur Erzeugung eines Kompensationsstroms veranschaulicht wird;
- Figur 2: einen Zeitverlauf des Kompensationsstroms im Blockschaltbild der Figur 1;
- Figur 3: eine Anordnung mit einem als Transduktor ausgebildeten magnetischer Schalter gemäß der Erfindung;
- Figur 4: eine B-H-Kennlinien-Darstellung welche das Wirkprinzips des magnetischen Schalters veranschaulicht;
- Figur 5: ein erstes Ausführungsbeispiel des magnetischen Schalters;
- Figur 6: ein zweites Ausführungsbeispiel des magnetischen Schalters;
- Figur 7: ein drittes Ausführungsbeispiel des magnetischen Schalters.

### Ausführung der Erfindung

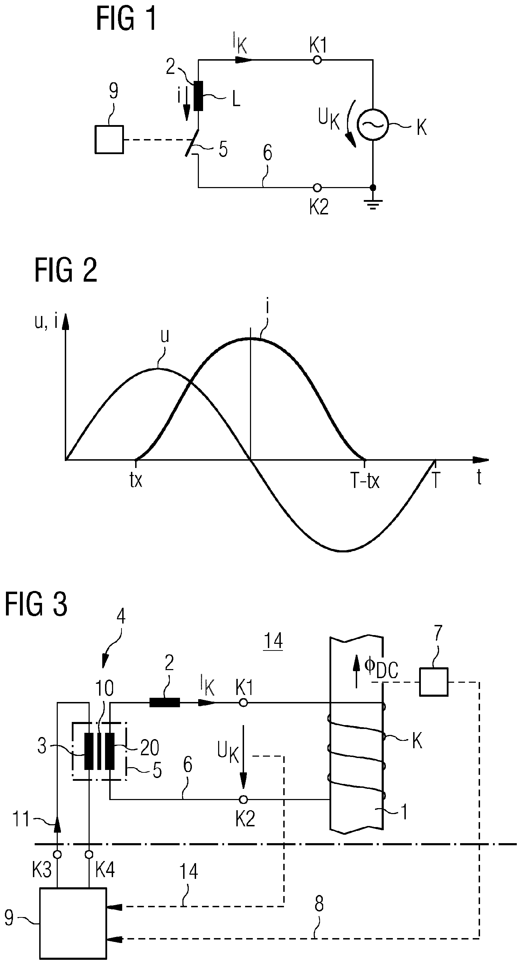

Vor Erläuterung der Ausführung der Erfindung soll anhand der Figur 1 und der Figur 2 das Wirkprinzip der Gleichfluss-Kompensation mittels eines getakteten Schaltelements kurz dargestellt werden. In Figur 1 ist die Kompensationswicklung K als Spannungsquelle U_{K} gezeichnet, d.h. der die Kompensationswicklung K durchsetzende Arbeits-Wechselfluss induziert in dieser eine Spannung U_{K}, die an den Klemmen K1, K2 der Kompensationswicklung K ansteht. Diese Spannung U_{K} wird als Energiequelle zur Erzeugung eines Kompensationsstroms I_{K} genutzt. Eine separate Energiequelle gibt es nicht. Die Erzeugung des Kompensationsstroms erfolgt durch eine getaktete Schalteinheit 5. Diese Schalteinheit 5 liegt in einem Strompfad 6 in Reihe mit der Kompensationswicklung K. Im Strompfad 6 befindet sich ferner eine Drossel 2. Die Drossel 2 dient zur Begrenzung des Stroms i im Strompfad 6, indem sie im Einschaltaugenblick durch ihre Induktivität L den Stromanstieg begrenzt. Um nun einen magnetischen Gleichfluss-Anteil Φ_{DC} in Kern 1 des Transformators zu kompensieren, wird der Schalter 5 von einer Steuereinheit 9 netzsynchron, aber im Einschaltzeitpunkt variabel getaktet, so dass sich im Strompfad 6 ein elektrischer Strom mit Oberschwingungen ausbildet, der einen Gleichanteil enthält, der in seiner Wirkung dem unerwünschten Gleichfluss Φ_{DC} im Kern des Transformators entgegenwirkt. Wie bereits gesagt, ist bei diesen Wirkprinzip eine externe Energiequelle in Form einer Batterie, oder eines Kondensator nicht erforderlich, die Energie stammt von der induzierten Spannung U_{K} selbst. Die Schalteinheit 5 kann aus Halbleitern gebildet sein, wie es beispielsweise in der eingangs erwähnten WO 2012/041368A1 offenbart ist. Geeignet sind Thyristoren in einer Phasenanschnittsteuerung, die bei einem bestimmten Phasenwinkel gezündet werden und automatisch bei Stromnulldurchgang wieder sperren. Die Größe des Gleichstroms kann über den Phasenwinkel, d.h. durch den Einschaltzeitpunkt, eingestellt werden.

Figur 2 zeigt den zeitlichen Verlauf des pulsierenden Gleichstroms. An den Klemmen K1, K2 steht die Spannung U(t)=U_{K} sin(ω*t) an. Bis zum Zündzeitpunkt tₓ ist der Schalter offen, daher i=0. Ab dem Zündzeitpunkt tₓ ist der Schalter 5 geschlossen und bleibt geschlossen bis zum nächsten Strom-Nulldurchgang (T-tₓ). Der zeitliche Verlauf des Stromes im Intervall [tₓ, T-tₓ] ergibt sich zu i(t)= U_{K}/ω*L (cos ((ω*tₓ) - cos ((ω*t).

Die Wirkungsweise des "magnetischen Schalters" wird im Folgenden näher erläutert.

Figur 3 zeigt ein Ausführungsbeispiel der erfindungsgemäßen Anordnung zur Kompensation eines magnetischen Gleichfluss-Anteils Φ_{DC} im Kern 1 eines nicht näher dargestellten Transformators. Zu sehen ist in Figur 3 ein Abschnitt des weichmagnetischen Kerns 1, der mit einer Kompensationswicklung K gekoppelt ist. Im Kern 1 fließe anteilsmäßig neben dem Wechselfluss auch ein störender magnetischer Gleichfluss Φ_{DC}.

Für die Kompensation dieser Gleichfluss-Anteils Φ_{DC} muss dieser zunächst in Größe und Richtung bekannt sein. Eine Möglichkeit zur Messung des Gleichfluss-Anteils Φ_{DC} ist beispielsweise in der PCT/EP2010/054857 vorgeschlagen, welche nach Art eines "magnetischen Bypass" arbeitet: mittels eines ferromagnetischen Nebenschluss-Teils wird ein Teil des magnetischen Hauptflusses am Transformatorkern abgezweigt und stromabwärts wieder zugeführt. Aus diesem abgezweigten und im Nebenschluss zum Kern geführten Flussanteil wird entweder direkt oder indirekt die magnetische Feldstärke in dem vom Nebenschlusszweig überbrückten Kernabschnitt ermittelt. Diese Erfassung der magnetischen Feldstärke, beziehungsweise der magnetischen Erregung, funktioniert zuverlässig und ist für einen Langzeiteinsatz gut geeignet. Es sind aber auch andere Methoden geeignet.

Um die Wirkung eines Gleichfluss-Anteils Φ_{DC} zu mindern ist gemäß der Erfindung in Figur 3 an den Klemmen K1 und K2 eine Sachalteinrichtung angeschlossen, mittels derer ohne externe Energiequelle ein Kompensationsstrom I_{K} erzeugt und in die Kompensationswicklung K eingespeist werden kann. Im Unterschied zum Stand der Technik weist diese Einrichtung keine leistungselektronischen Baukomponenten auf. Sie besteht im Wesentlichen aus einem stromsteuernden Leistung-Transduktor 4. Dieser Transduktor 4 wirkt als getakteter Schalter, d.h. seine Steuerwicklung 3 wird mit einem Steuerstrom 11 beaufschlagt, der in seine Größe veränderlich ist und vom Netz getriggert wird, wodurch im Strompfad 6 eine Schaltfunktion erzielt wird. Im Strompfad 6 sind in elektrischer Hintereinanderschaltung drei Induktivitäten 20, 2 und K, angeordnet, wobei Letztere in Figur 3 nicht als Symbol, sondern schematisch gezeichnet ist.

In der praktischen Ausführung befinden sich in der Darstellung der Figur 3 die Baugruppen unterhalb der strichpunktierten Linie nicht im Innenraum 14 des Transformatorkessels, sondern außerhalb.

Die Strombegrenzungs-Drossel 2 und die Arbeitswicklung 20 des Transduktors 4 können auch zu einer Induktivität L zusammengefasst sein.

Im Folgenden wird die Erzeugung und Einspeisung des Kompensationsstroms I_{K} in die Kompensationswicklung K näher erläutert.

Die Erzeugung des Kompensationsstroms I_{K} erfolgt wie gesagt durch die magnetisch wirkende Schalteinrichtung 5 nach Art eines Transduktors. Dieser besteht im Wesentlichen aus einer Wicklungsanordnung 3, 20, gebildet aus einer Steuerwicklung 3 und einer Arbeitswicklung 20, die mit einem magnetischen Kern 10 gekoppelt sind. Der Kern 10 ist geschlossen und weist keinen Luftspalt auf. Der magnetische Werkstoff im Kern 10 wird mittels des in der Steuerwicklung 3 fließenden Steuerstroms 11 vormagnetisiert, d.h. zwischen dem Zustand der Sättigung und dem der Nicht-Sättigung ausgesteuert.

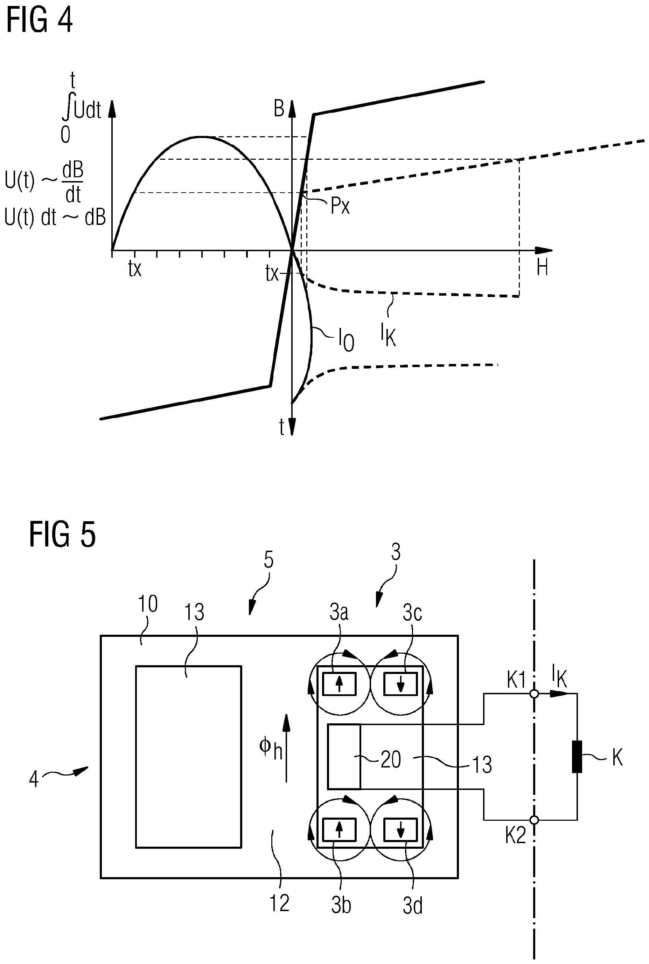

Figur 4 veranschaulicht das Wirkprinzip der Schalteinrichtung anhand der B-H-Kennlinie des Kerns 10. Die durchgezogenen Linien zeigen den nicht gezündeten Zustand, die unterbrochenen Linien den durchgeschalteten Zustand:
Wenn der Kern 10 nicht in der Sättigung ist, das heißt die Induktivität groß ist, ist die Impedanz groß und es fließt im Strompfad 6 nur ein sehr kleiner Erregerstrom I₀. Der Schalter 5 kann als sperrend bzw. geöffnet angesehen werden.

Wenn der Kern 10 beginnend im Zeitpunkt tₓ mittels der Steuerwicklung 3 teilweise, dann vollständig (siehe Punkt Pₓ in Figur 4) in die Sättigung gebracht wird, so sinkt die Induktivität stark ab und es beginnt im Strompfad 6 ein zunehmend größerer Strom I_{K} zu fließen. Der mit diesem Strom I_{K} verkettete Fluss hält das Magnetmaterial des Kerns 10 in Sättigung, so dass die Initialzündung durch den Strom 11 in der Steuerwicklung 3 nicht mehr erforderlich ist und abgeschaltet werden kann. (Diese Leiteigenschaft ist ähnlich einem Thyristor: Der einmal gezündete Thyristor kann über den Steueranschluss nicht mehr gesteuert werden, insbesondere nicht mehr gelöscht werden.) In diesem Zustand befindet sich die Schaltvorrichtung 5 also in einem leitenden Zustand, d.h. der Schalter 5 ist geschlossenen. Dieser durchgeschaltete Zustand dauert so lange, bis der Wechselstrom-Nulldurchgang erreicht ist. Dann ist der Stromfluss unterbrochen und es muss der Schalter 5 für einen nächsten Schaltvorgang neu gezündet werden. Die Drossel 2 dient im durchgeschalteten Zustand zur Strombegrenzung.

Je nach Größe und Richtung des zur GIC- bzw. DC-Kompensation erforderlichen Kompensationsstroms I_{K}, wird der Einschaltzeitpunkt tₓ so gesteuert, dass der resultierende arithmetische Mittelwert des pulsierenden Stroms in der Kompensationswicklung K die gewünschte Φ_{DC}-Kompensationswirkung hervorruft. Der Einschaltzeitpunkt tₓ bestimmt das Ausmaß der GIC- bzw. DC-Kompensations-Wirkung. Getriggert wird dieser "Zünd-" bzw. Einschaltvorgang phasensynchron, d.h. im Gleichlauf zur Spannung in der Kompensationswicklung K. Das Bestromen der Steuerwicklung 3 ist also ähnlich dem leitendschalten eines Halbleiters, zum Beispiel dem Zünden eines Thyristors. Wie beim Thyristor kommt es nach dem "Zünden" zu einem Stromfluss, der selbstständig wiederum erlischt. Zunächst hält sich der magnetische Schalter 5 selbst in Sättigung bis zum Stromnulldurchgang oder nahe dem Stromnulldurchgang, wo die Sättigung des Eisenkreises wieder aufgehoben wird. Dann hat der magnetische Schalter wieder eine hohe Induktivität und kann als sperrend, d.h. in seinem Schaltzustand als ein geöffneter Schalter angesehen werden.

Wie oben dargestellt, erfolgt die Einspeisung des Steuerstroms 11 zu einen im Gleichlauf mit dem Netz, zum anderen erfolgt die Vorgabe von Größe und Richtung des Steuerstroms 11 nach Maßgabe des zu kompensierenden magnetischen Gleichfluss-Anteils Φ_{DC}. Deswegen sind der Steuereinrichtung 9 eingangsseitig zwei Signale zugeführt: erstens, die an den Klemmen K1, K2 anstehende induzierte Spannung U_{K} der Kompensationswicklung K , woraus der Einschaltzeitpunkt netzsynchron, d.h. phasensynchron zur Spannung U_{K} in der Kompensationswicklung vorgegeben werden kann, und zweitens, ein Messsignal 8, welches von einer Messeinrichtung 7 stammt, die den magnetischen Gleichfluss-Anteil Φ_{DC} detektiert. Erfassung und Verarbeitung dieser beiden Signale 8, 14 ist bekannt und kann beispielsweise der bereits oben erwähnten PCT/EP2010/054857 entnommen werden.

Der magnetisch wirkende Schalter 5 kann unterschiedliche ausgeführt sein:
Figur 5 zeigt eine erste mögliche Ausführungsform des erfindungsgemäßen Schalters 5. Dargestellt ist ein Kern 10 der Schalteinheit 5 beispielhaft in Form eines Einphasen-Mantelkerns. Die Figur 5 zeigt der Einfachheit wegen nur die rechte Symmetriehälfte. Der mittlere Schenkel 12 trägt die Arbeitswicklung 20 des Transduktors 4. Über den Kern 10 sind die Steuerwicklung 3 und Arbeitswicklung 20 miteinander magnetisch gekoppelt. Die Steuerwicklung 3 besteht aus mehreren Einzelwicklungen oder Hilfswicklungen 3a, 3b, 3c, 3d. Diese Hilfswicklungen 3a, 3b, 3c, 3d sind im Fenster 13 des 1-Schenkelkerns oben und unten angeordnet. Sie sind mit ihren Wicklungsenden so miteinander verschaltet, dass der magnetische Werkstoff des Kerns 10 zwischen Sättigung und Nicht-Sättigung geschalteten werden kann, je nach Richtung des Gleichstromes in der Hilfswicklung-Anordnung 3a, 3b, 3c, 3d.

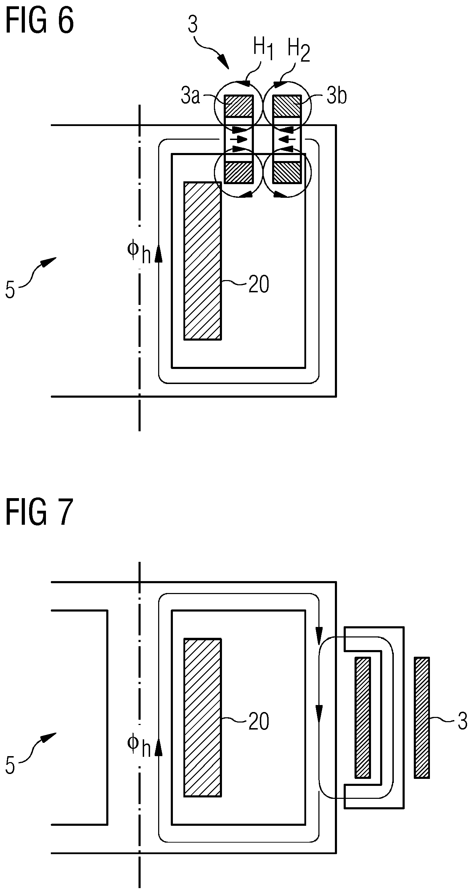

Figur 6 zeigt eine zweite Ausführungsform eines Transduktors, bei der im Fenster oben zwei Hilfswicklungen 3a, 3b angeordnet sind, die mit gegensätzlichem Wickelsinn aber gleicher Windungszahl in Reihe geschaltet sind. Der Fluss Φₕ im Transduktor 5 induziert eine Spannung die sich dann zu Null ergibt. Dies erleichtert die Einspeisung des Steuerstroms 11.

Figur 7 zeigt eine dritte Ausführungsform eines Transduktors, bei der mittels einer Steuer- bzw. Hilfswicklung 3 und über einen Luftspalt L die Sättigung im Kern 10 des Transduktors 4 entsprechend dem gewünschten Schaltverhalten verändert wird. Die Einkopplung über den Luftspalt bewirkt, dass das Abschalten der Hilfswicklungs-Bestromung bei möglichst kleiner induzierter Spannung erfolgen kann.

Wie bereits gesagt, hat die erfindungsgemäße halbleiterlose Schaltvorrichtung 5 den großen Vorteil, dass eine höhere Zuverlässigkeit und Betriebssicherheit erreicht werden kann. Die Erfindung ermöglicht die Anwendung der DCC-(Direct Current Compensation)-Technologie in Transformatoren sehr hoher Leistungsklasse. Mit geringem technischem Aufwand kann eine vergleichsweise hohe Spannung an der Kompensationswicklung bewältigt werden. Die Anwendung ist nicht mehr auf Spannungen innerhalb der Niederspannungsrichtlinie, d.h. bis 690 V beschränkt. Der Leistung-Transduktor kann zur Kompensation von GIC eingesetzt werden, wo vergleichsweise hohe Kompensationsströme erforderlich sind. Dies war bislang nicht möglich, da die Anwendung von Thyristoren wegen der Verlustleistung nicht nur technisch begrenzt, sondern auch wirtschaftlich kaum vertretbar sind. Darüber hinaus ist es schwer mir einer Halbleiterschalteinrichtung über einen langen Betriebszeitraum die geforderte Zuverlässigkeit zu garantieren. Ein großer Kühlkörper und eventuelle Gebläsekühlung, wie Sie bei Halbleiterschaltelementen stets vonnöten ist, ist dank der Anordnung im Kesselinneren nicht erforderlich.

Ein weiterer Vorteil ist, dass der erfindungsgemäße Schalter in den Transformatorkessel eingebaut werden kann, was den Vorteil einer Flüssigkeitskühlung mit sich bringt. Eine effiziente und zuverlässige Kühlung ermöglicht die Anwendung der Gleichfluss-Kompensation bei Transformatoren sehr großer Leistung, zum Beispiel für HGÜ-Transformatoren.

Zur Erzeugung des Kompensationsstroms dient als Energiequelle die in der Kompensationswicklung induzierte Spannung. Es ist kein separater Energiespeicher, wie eine Batterie oder ein Kondensator, erforderlich.

Es ist ferner von Vorteil, dass die Schaltvorrichtung gemäß der Erfindung im Wesentlichen aus Materialien gebildet wird, wie Sie im Transformatorenbau auch sonst verwendet werden (isolierte Wicklungsdrähte, weichmagnetische Kernwerkstoffe). Die Handhabung dieser Werkstoffe ist dem Hersteller eines Transformators geläufig. Die Kosten bei der Herstellung sind im Vergleich zu einer Lösung mit Halbleitern weitaus geringer. Verglichen mit einem Halbleiterschalter, bei dem eine Lebensdauer von weniger als 15 Jahren angesetzt werden muss, hat der erfindungsgemäße "induktive Schalter" eine vergleichsweise höhere Lebensdauer. Elektrische Transformatoren, die in Netzen der Energieversorgung und - verteilung eingesetzt werden, sind langfristige Investitionsgüter, denen eine hohe Lebensdauer und Zuverlässigkeit abverlangt wird. Dem Kunden, d.h. dem Netzbetreiber ist der Wegfall leistungselektronischer Baukomponenten willkommen, da sein Blick stets auf Zuverlässigkeit und lange Lebensdauer gerichtet ist.

Zusammenfassend lässt sich sagen, dass durch die Erfindung die Leistungselektronik obsolet geworden ist, und vollständig durch eine passive Lösung ersetzt werden kann. Zur Kompensation eines Gleichfluss-Anteils benötigt man also keine Halbleiterbauelemente mehr, lediglich die Steuerelektronik zur Ansteuerung der Schalteinrichtung und die Messeinrichtung zum Erfassen des Gleichfluss-Anteils.

Zusammenstellung der verwendeten Bezugszeichen
- 1: Kern eines Transformators
- 2: Drossel zur Strombegrenzung
- 3: Steuerwicklung
- 3a, 3b, 3c, 3d: Hilfswicklung
- 4: Transduktor
- 5: Schalteinrichtung
- 6: Strompfad
- 7: Messeinrichtung
- 8: Messsignal
- 9: Steuereinrichtung
- 10: Kern
- 11: Steuergröße, Steuerstrom
- 12: mittlerer Schenkel von 10
- 13: Fenster
- 14: Innenraum

- 20: Arbeitswicklung

- K: Kompensationswicklung
- K1, K2: Klemmen der Kompensationswicklung
- K3, K4: Klemmen der Steuerwicklung

- U_{K}: in der Kompensationswicklung induzierte Spannung
- I_{K}: Kompensationsstrom
- I₀: Magnetisierungsstrom

- Φ_{DC}: Gleichfluss-Anteil
- Φₕ: Magnetfluss in 4

- B: Flussdichte
- H: Feldstärke
- U: Spannung
- T,t: Zeit
- L: Induktivität

## Patentansprüche

1. Anordnung zur Verringerung eines magnetischen Gleichfluss-Anteils (Φ_{DC)} im Kern (1) eines Transformators, umfassend:
- eine Messeinrichtung (7), welche geeignet ist ein dem magnetischen Gleichfluss-Anteil (Φ_{DC}) entsprechendes Messsignal (8) bereitzustellen,
- eine Kompensationswicklung (K), welche magnetisch mit dem Kern (1) des Transformators koppelbar ist, wobei die Kompensationswicklung so angeordnet ist, dass der im Kern (1) fließende magnetische Fluss in der Kompensationswicklung eine Spannung (U_{K}) induziert,
- eine Schaltvorrichtung (5), welche elektrisch in einem Strompfad (6) in Reihe mit der Kompensationswicklung (K) angeordnet ist,
- eine Steuereinrichtung (9), welche die Schaltvorrichtung (5) mittels einer Steuergröße (11) so steuert, dass die Schaltvorrichtung (5) zu einem Einschaltzeitpunkt in einen leitenden Zustand schaltbar ist, wobei der Einschaltzeitpunkt vom Messsignal (8) abhängig ist und phasensynchron zur Spannung (U_{K}) in der Kompensationswicklung (K) ist, wodurch in die Kompensationswicklung (K) ein Kompensationsstrom (I_{K}) eingespeist wird, dessen Wirkung dem Gleichfluss-Anteil (Φ_{DC}) entgegen gerichtet ist, wobei
- die Schaltvorrichtung (5) durch einen magnetischen Kern (10) und eine mit diesem Kern (10) magnetisch gekoppelte Wicklungsanordnung (3,20) gebildet ist,
- die Steuergröße (11) der Wicklungsanordnung (3,20) zugeleitet ist, so dass der magnetische Sättigungszustand des Kerns (10) änderbar ist, wodurch der leitende Zustand der Schaltvorrichtung (5) hergestellt ist,
**dadurch gekennzeichnet, dass** die Wicklungsanordnung (3, 20) aus einer Steuerwicklung (3), die zum Zwecke zur Einleitung eines Steuerstroms mit der Steuereinrichtung (9) verbunden ist, und einer Arbeitswicklung (20), die in den Strompfad (6) eingebunden ist, gebildet ist.

2. Anordnung nach Anspruch 1, **dadurch gekennzeichnet, dass** die Arbeitswicklung (20) gleichzeitig als Einrichtung zur Strombegrenzung im Strompfad (6) ausgebildet ist.

3. Anordnung nach einem der vorstehenden Ansprüche, **dadurch gekennzeichnet, dass** die Schaltvorrichtung (5) im Innenraum (14) eines mit einer Isolations- und Kühlflüssigkeit gefüllten Transformatorkessels angeordnet ist.

## Claims

1. Arrangement for reducing a magnetic unidirectional flux component (Φ_{DC}) in the core (1) of a transformer, comprising:
- a measurement apparatus (7), which is suitable for providing a measurement signal (8) corresponding to the magnetic unidirectional flux component (Φ_{DC}),
- a compensation winding (K), which can be magnetically coupled to the core (1) of the transformer, wherein the compensation winding is arranged such that the magnetic flux flowing in the core (1) induces a voltage (U_{K}) in the compensation winding,
- a switch device (5), which is arranged electrically in series with the compensation winding (K) in a current path (6),
- a control device (9), which controls the switch device (5) by means of a control parameter (11) such that the switch device (5) can be switched to a conductive state at an activation time, wherein the activation time is dependent on the measurement signal (8) and is phase-synchronous to the voltage (U_{K}) in the compensation winding (K), whereby a compensation current (I_{K}) is injected into the compensation winding (K), the effect of which is directed against the unidirectional flux component (Φ_{DC}).
wherein
- the switch device (5) is formed by a magnetic core (10) and a winding arrangement (3,20) which is magnetically coupled to this core (10),
- the control parameter (11) is supplied to the winding arrangement (3,20) such that the magnetic saturation state of the core (10) can be varied, whereby the conductive state of the switch device (5) is produced,
**characterised in that** the winding arrangement (3, 20) is formed of a control winding (3), which is connected to the control device (9) for the purpose of introducing a control current, and a load winding (20), which is integrated into the current path (6).

2. Arrangement according to claim 1, **characterised in that** the load winding (20) is simultaneously configured as a device for limiting the current in the current path (6).

3. Arrangement according to one of the preceding claims, **characterised in that** the switch device (5) is arranged in the internal space (14) of a transformer tank which is filled with an insulating and cooling liquid.

## Revendications

1. Système pour diminuer une part d'un flux magnétique continu (**Φ**_{DC}) dans un noyau (1) d'un transformateur, comprenant :
- un dispositif de mesure (7) qui est adapté pour fournir un signal de mesure (8) correspondant à la part de flux continu magnétique (**Φ**_{DC}),
- un enroulement de compensation (K) qui peut être couplé magnétiquement au noyau (1) du transformateur et qui est agencé de telle manière que le flux magnétique s'écoulant dans le noyau (1) induit dans l'enroulement de compensation une tension (U_{K}),
- un dispositif de commutation (5) qui est disposé électriquement dans un trajet de courant (6) en série avec l'enroulement de compensation (K), et
- un dispositif de commande (9) qui commande le dispositif de commutation (5) au moyen d'une grandeur de commande (11) de telle manière que le dispositif de commutation (5) est commutable à un moment d'enclenchement dans un état conducteur, le moment d'enclenchement dépendant du signal de mesure (8) et étant synchronisé en phase avec la tension (U_{K}) dans l'enroulement de compensation (K), au moyen de quoi un courant de compensation (I_{K}) est injecté dans l'enroulement de compensation (K), dont l'effet est dirigé en sens inverse de la part de flux magnétique continu (**Φ**_{DC}),
dans lequel
- le dispositif de commutation (5) est formé par un noyau magnétique (10) et un agencement d'enroulement (3, 20) couplé magnétiquement à ce noyau (10),
- la grandeur de commande (11) est amenée à l'agencement d'enroulement (3, 20) de telle sorte que l'état de saturation magnétique du noyau (10) peut être modifié,
au moyen de quoi l'état conducteur du dispositif de commutation (5) est produit,
**caractérisé en ce que** l'agencement d'enroulement (3, 20) est constitué d'un enroulement de commande (3) qui est relié au dispositif de commande (9) pour y introduire un courant de commande, et d'un enroulement de travail (20) qui est intégré dans le trajet de courant (6).

2. Système selon la revendication 1, **caractérisé en ce que** l'enroulement de travail (20) est conçu en même temps sous forme d'un dispositif de limitation de courant dans le trajet de courant (6).

3. Système selon l'une quelconque des revendications précédentes, **caractérisé en ce que** le dispositif de commutation (5) est disposé dans l'espace intérieur (14) d'une cuve de transformateur remplie avec un liquide isolant et de refroidissement.
